# EUROPEAN PATENT SPECIFICATION

(11) **EP 2 957 762 B1**
(45) Date of publication and mention of the grant of the patent: **23.11.2016**
(21) Application number: 15163084.5
(22) Date of filing: 10.04.2015
(51) Int. Cl.: F02P 19/02, H01H 37/76, H03K 17/082, H03K 17/18, H03K 17/687, H05K 3/46, H05K 1/02, H02H 5/04, H03K 17/0814

(54) **CONTROL APPARATUS**
STEUERUNGSVORRICHTUNG
APPAREIL DE CONTRÔLE

(30) Priority: 23.04.2014 JP 2014088943
(43) Date of publication of application: 23.12.2015
(73) Proprietor: NGK Spark Plug Co., Ltd., Nagoya-shi, Aichi 467-8525 (JP)
(72) Inventor: Kumazawa, Shinji, Nagoya, Aichi 467-8525 (JP); Toda, Satoru, Nagoya, Aichi 467-8525 (JP)
(74) Representative: Grünecker Patent- und Rechtsanwälte PartG mbB

(56) References cited:
- EP-A1- 1 811 819
- GB-A- 2 300 340
- US-A1- 2007 103 006
- US-B1- 6 445 277

## Description

### [Technical Field]

The present invention relates to a control apparatus in which an IC package or the like including a semiconductor switch is disposed on a printed circuit board.

### [Background Art]

Patent Document 1 discloses a control apparatus which includes a transistor switch for driving a heater element of an automobile such as a glow plug, and a control circuit for controlling the transistor switch. In this control apparatus, an overheat protection element whose contact connection is cancelled when its temperature exceeds a limiting temperature is provided on at least one of the high side (high voltage side) and the low side (low voltage side) of the transistor switch. The overheat protection element is configured such that the electrical connection between conductor members is formed by means of soldering, and a mechanical stress (e.g., spring force) is applied to the electrically connected portion. When the temperature exceeds the limiting temperature, the solder melts and the electrical connection is broken by the spring force.

According to the technique of Patent Document 1, when the temperature of the control apparatus becomes high as a result of occurrence of a failure in the transistor switch or the control circuit therefor, the electrical connection in the overheat protection element is broken, whereby overheating of the control apparatus can be prevented.

### [Prior Art Document]

### [Patent Document]

[Patent Document 1] Japanese *Kohyo* (PCT) Patent Publication No. 2008-530727

### [Summary of the Invention]

### [Problems to be Solved by the Invention]

The inventors of the present application found that there is a problem in that, when a semiconductor switch (transistor) breaks, due to the heat generated from the semiconductor switch, the insulating layer of a printed circuit board is heated excessively and is carbonized, whereby a short circuit is formed between conductor traces. In such a case, even when an overheat prevention element functions, a large leak current flows. Conventionally, such a problem has not yet been recognized sufficiently.

### [Means for Solving the Problems]

The present invention has been accomplished so as to solve the above-described problems, and the present invention can be realized as the following modes.
(1) According one mode of the present invention, there is provided a control apparatus in which a switch IC is disposed on a multi-layer printed circuit board having N (N is an integer equal to or greater than 3) wiring layers, the switch IC being an IC package including a semiconductor switch for driving a resistive load. In the control apparatus, when M (M is an integer which is not less than 2 but not greater than N) wiring layers of the N wiring layers of the printed circuit board, the number of the M wiring layers being counted from a surface on which the switch IC is mounted, and the switch IC are projected in a thickness direction of the printed circuit board, in a region which overlaps with a die of the semiconductor switch, (i) a current path trace on a high voltage side of the semiconductor switch is present, and (ii) a signal ground connection wiring trace and a current path trace on a low voltage side of the semiconductor switch are not present.
   According to this configuration, even when the insulating layers of the printed circuit board are carbonized by the heat generated from a broken semiconductor switch, no short circuit is formed between the current path trace on the high voltage side of the semiconductor switch and the signal ground connection wiring trace or the the current path trace on the low voltage side of the semiconductor switch. Therefore, generation of large leak current can be prevented.
(2) The above-described control apparatus may be such that, when the M wiring layers of the printed circuit board and the switch IC are projected in the thickness direction of the printed circuit board, other wiring traces which differ in potential from the current path trace on the high voltage side of the semiconductor switch are not present in the region which overlaps with the die of the semiconductor switch.
   This configuration can further restrain occurrence of a fault in which a large current flows between the current path trace on the high voltage side of the semiconductor switch and another wiring trace when the insulating layers of the printed circuit board are carbonized by the heat generated from the broken semiconductor switch.
(3) The above-described control apparatus may be such that, when the M wiring layers of the printed circuit board and the switch IC are projected in the thickness direction of the printed circuit board, wiring traces other than the current path trace on the high voltage side of the semiconductor switch are not present in the region which overlaps with the die of the semiconductor switch.
   This configuration can further restrain occurrence of the fault in which a large current flows between the current path trace on the high voltage side of the semiconductor switch and another wiring trace.
(4) In the above-described control apparatus, the integer M may be equal to the integer N.

This configuration can further restrain occurrence of the fault in which a large current flows between the current path trace on the high voltage side of the semiconductor switch and another wiring trace.

Notably, the present invention can be realized in various forms. For example, the present invention can be realized as a control apparatus, a method for manufacturing a control apparatus, or a method for disposing electronic components.

### [Brief Description of the Drawings]

[FIG. 1] Plan view of a control apparatus which is one embodiment.
[FIG. 2] Block diagram showing the circuit configuration of the control apparatus.
[FIGS. 3(A) through 3(D)] Explanatory vies showing portions of wiring traces of four layers, counted from the upper side, of a printed circuit board.
[FIGS. 4(A) and 4(B)] Schematic views showing for comparison a cross section of a multi-layer wiring trace of the embodiment and a cross section of a multi-layer wiring trace of a comparative example.
[FIGS. 5(A) and 5(B)] Schematic views showing for comparison a case in which a carbonized portion is formed in the embodiment and a case in which a carbonized portion is formed in the comparative example.
[FIG. 6] Block diagram showing an example of another circuit configuration of the control apparatus.

### [Modes for Carrying out the Invention]

### A. Overall Configuration of Control Apparatus

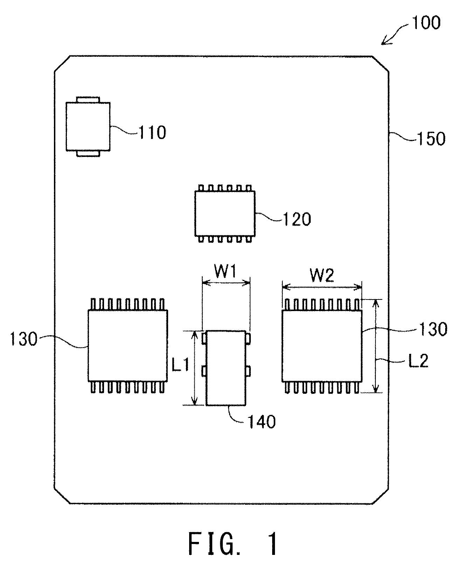

FIG. 1 is a plan view of a control apparatus 100 which is one embodiment of the present invention. This control apparatus 100 is configured as an apparatus for controlling a resistive load (e.g., a glow plug) for an automobile. This control apparatus 100 has a structure in which a power supply circuit 110, a controller IC 120, two switch ICs 130, and a thermal fuse 140 are disposed on a printed circuit board 150. The thermal fuse 140 is disposed at a position between the two switch ICs 130. Notably, although the control apparatus 100 includes electronic components other than the above-mentioned components, wiring traces, and various terminals, these are not shown in FIG. 1.

Each of the power supply circuit 110, the controller IC 120, and the switch ICs 130 is an electronic component constituted by an IC package. In the example of FIG. 1, the four types of components 110, 120, 130, and 140 are configured as surface-mount-type packages. Each of the switch ICs 130 is an IC package including a semiconductor switch. However, it is preferred that each of the switch ICs 130 be an IC package called IPD (Intelligent Power Device) which includes not only a semiconductor switch (e.g., an FET) but also a control circuit for the semiconductor switch (e.g., an FET gate drive circuit) and an overheat protection circuit.

In the example of FIG. 1, the dimension of the thermal fuse 140 in the longitudinal direction thereof is L1, and the dimension of the thermal fuse 140 in the lateral direction (width direction) thereof is W1. The dimension of each switch IC 130 in the longitudinal direction thereof is L2, and the dimension of each switch IC 130 in the lateral direction (width direction) thereof is W2. In general, L1 < L2 and W1 < W2. The longitudinal and lateral dimensions of each package are those of the contour of the entire package including both a mold portion and lead wires thereof.

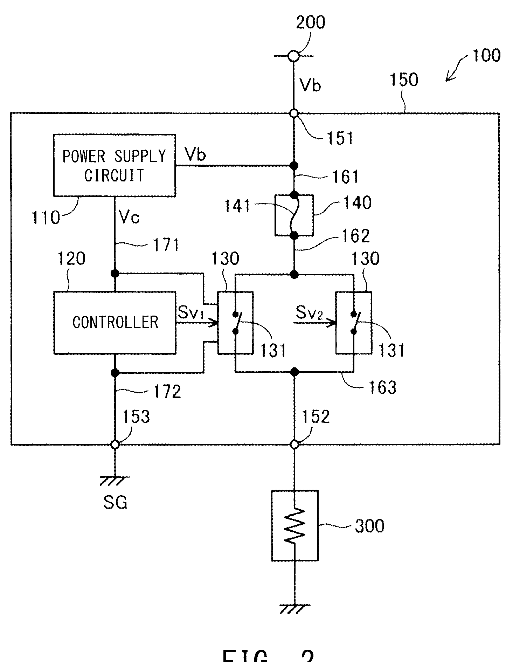

FIG. 2 is a block diagram showing the circuit configuration of the control apparatus 100 shown in FIG. 1. A power supply input terminal 151, a load connection terminal 152, and a signal ground terminal 153 are provided on the printed circuit board 150. A predetermined external power supply voltage Vb (DC voltage) is supplied to the power supply input terminal 151 from an external battery 200. This external power supply voltage Vb is supplied to the power supply circuit 110 and the thermal fuse 140 through a wiring trace 161 for external power supply.

The power supply circuit 110 produces, from the external power supply voltage Vb, a control power supply voltage Vc supplied to the controller IC 120 and control circuits (not shown) within the switch ICs 130. This control power supply voltage Vc is supplied to various control circuits disposed on the printed circuit board 150 through a wiring trace 171 for power supply. The various circuits, including the controller IC 120, are electrically connected to the signal ground terminal 153 of the printed circuit board 150 through a wiring trace 172 for signal ground. This wiring trace 172 is wiring for connecting the various circuits to a signal ground SG, and is also referred to as the "signal ground connection wiring 172." Neither a passive element nor an active element is present between the signal ground SG and the signal ground connection wiring 172. Therefore, the signal ground connection wiring 172 is a wiring line which is connected to the signal ground SG through only a wiring trace whose impedance is ignorable. The signal ground terminal 153 is connected to the signal ground SG provided on the printed circuit board 150 or outside the printed circuit board 150. Notably, in the case where the signal ground SG is realized by a wiring trace provided on the printed circuit board 150, the signal ground terminal 153 may be omitted. Also, the signal ground connection wiring 172 itself may be configured as a large wiring trace which functions as the signal ground SG.

The output terminal of the thermal fuse 140 is electrically connected to the current input terminals of the two switch ICs 130 through a first wiring trace 162 for current path. This wiring trace 162 corresponds to a current path trace on the high side (high voltage side) of the semiconductor switch 131 within each switch IC 130. The current output terminals of the two switch IC 130 are electrically connected to the load connection terminal 152 of the printed circuit board 150 through a second wiring trace 163 for current path. This wiring trace 163 corresponds to a current path trace on the low side (low voltage side) of the semiconductor switch 131 within each switch IC 130. The load connection terminal 152 is connected to the input terminal of a resistive load 300 (e.g., a glow plug) of an automobile. The output terminal of the resistive load 300 is grounded. In this configuration, the semiconductor switches 131 of the switch ICs 130 are used to drive the resistive load 300 on the high side thereof. Notably, three or more switch ICs 130 may be provided in parallel.

The controller IC 120 turns on and off the two semiconductor switches 131 by supplying control signals Sv1 and Sv2 to the two switch ICs 130, to thereby energize and de-energize the resistive load 300. Notably, in the case where each switch IC 130 includes an FET gate drive circuit for driving the semiconductor switch 131, the control signals Sv1 and Sv2 supplied from the controller IC 120 may be signals each indicating a duty ratio used in PWM control.

The thermal fuse 140 is an overheat prevention component including a passive element 141 for preventing overheating of the switch ICs 130. When the temperature of a switch IC 130 rises excessively due to a failure or a malfunction, the electrical connection within the thermal fuse 140 is broken as a result of the temperature rise, whereby current is interrupted. Heat is conducted from the switch ICs 130 to the thermal fuse 140 through mainly the wiring trace 162 between the switch ICs 130 and the thermal fuse 140. The passive element 141 of the thermal fuse 140 may be an element having a structure in which, when solder joining the electrical contacts of the passive element 141 melts as a result of a temperature rise, the electrical contacts are separated from each other through use of mechanical stress produced by a spring or the like. A coil spring or the like may be used as a spring which produces such mechanical stress. However, in FIG. 2, for convenience of depicting, the passive element 141 of the thermal fuse 140 is depicted as a simple fusible fuse. Notably, in the present embodiment, the resistive load 300 of the control apparatus 100 is a glow plug. Therefore, it is preferred to use, as the thermal fuse 140, a thermal fuse through which a large current for the glow plug can be caused to flow. Specifically, it is preferred that the thermal fuse 140 have an interrupting current (or a maximum rush current) of 200 A or greater. In this case, overheating of a plurality of switch ICs can be prevented through use of a single thermal fuse 140.

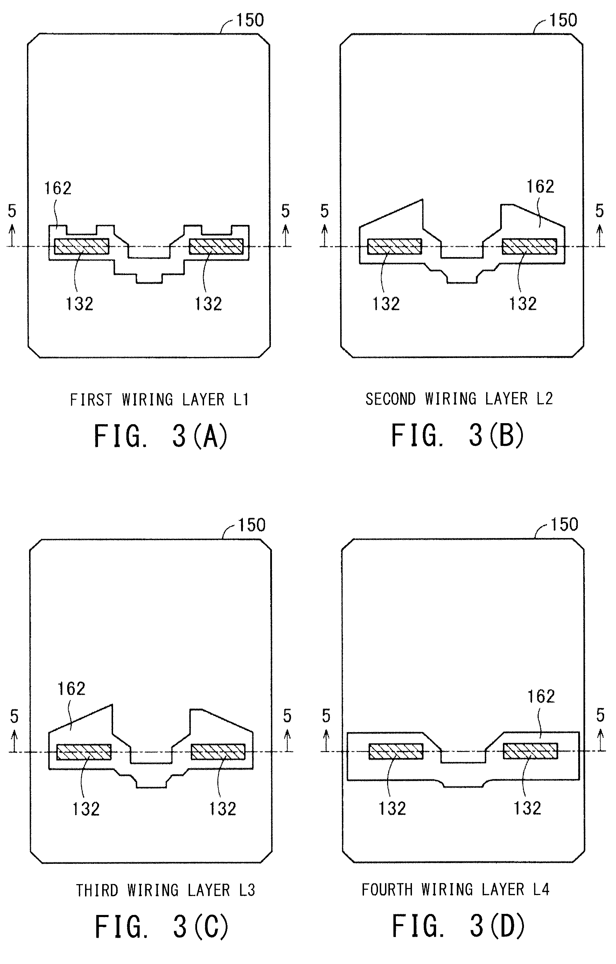

FIGS. 3(A) through 3(D) are explanatory views showing portions of four wiring layers L1 through L4 of the printed circuit board 150, counted from the upper side. The printed circuit board 150 is a multi-layer board, and has a plurality of wiring layers. FIG. 3(A) shows only a portion of the uppermost wiring layer L1 which corresponds to the wiring trace 162 (FIG. 2) on the high side of the semiconductor switch 131. In FIG. 3(A), shapes formed as a result of projection of dies 132 (i.e., semiconductor chips) of the semiconductor switches 131 are also depicted with hatching. In FIGS. 3(B), 3(C), and 3(D), the wiring trace 162 and the dies 132 in the second, third, and fourth wiring layers L2 through L4 from the upper side are depicted in a similar manner. Notably, although the fifth layer and other lower layers are not illustrated, these layers are substantially the same as the above-mentioned layers. Also, in FIGS. 3(A) through 3(D), vias for connecting layers are not shown. Notably, FIGS. 3(A) through 3(D) correspond to views which are obtained by projecting the switch ICs 130 and the wiring layers L1 through L4 of the printed circuit board 150 in the thickness direction of the printed circuit board 150 and which show the positional relation therebetween. As can be understood from these drawings, it is preferred that, under the dies 132 of the semiconductor switches 131, only the wiring trace 162 on the high side of the semiconductor switches 131 be provided, and no other wiring traces be provided.

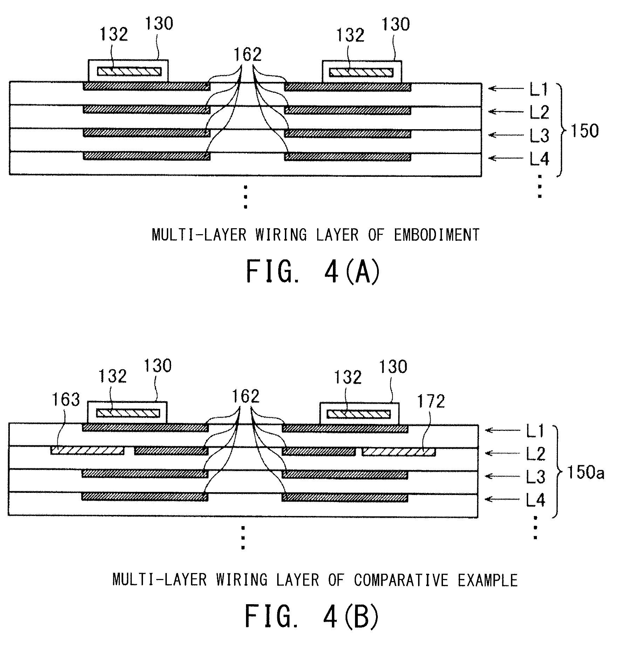

FIGS. 4(A) and 4(B) are schematic views showing for comparison a cross section of a multi-layer wiring trace of the embodiment and a cross section of a multi-layer wiring trace of a comparative example. FIG. 4(A) shows 5-5 cross sections of the four wiring layers L1 through L4 shown in FIGS. 3(A) through 3(D). However, the dimensions of various portions of FIGS. 4(A) and 4(B) are not accurate, and are not exactly the same as those in FIGS. 3(A) through 3(D). In particular, the dimension in the thickness direction of the printed circuit board 150 is greater than the actual dimension due to exaggeration in depiction. Also, in FIGS. 4(A) and 4(B) as well, vias for connecting layers are not illustrated. In the embodiment shown in FIG. 4(A), in the wiring layers L1 through L4 of the printed circuit board 150, under the dies 132 of the semiconductor switches 131 of the switch ICs 130, only the wiring trace 162 on the high side of the semiconductor switches 131 is provided, and other wiring traces are not provided. Meanwhile, in the comparative example shown in FIG. 4(B), in the wiring layers L1 through L4 of a printed circuit board 150s, not only the wiring trace 162 on the high side of the semiconductor switches 131 but also two other types of wiring traces 163 and 172 are provided under the dies 132 of the semiconductor switches 131 of the switch ICs 130. The wiring trace 163 is a wiring trace on the low side of the switch ICs 130, and the wiring trace 172 is a signal ground connection wiring trace. In the case where these two types of wiring traces 163 and 172 are disposed under the dies 132, the following problem may occur.

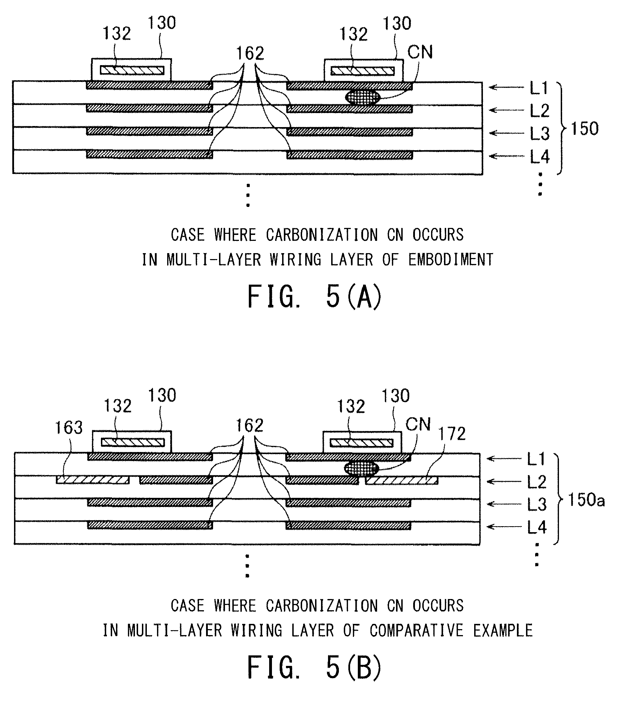

FIGS. 5(A) and 5(B) show a case in which a carbonized portion CN is formed in the embodiment and a case in which a carbonized portion CN is formed in the comparative example. In these cases, a failure occurs in the semiconductor switch 131 of one switch IC 130 (the switch IC 130 on the right side), and the insulating layers of the printed circuit board 150 are heated excessively and are carbonized, whereby the carbonized portion CN is formed. In the embodiment shown in FIG. 5(A), only the wiring trace 162 on the high side of the semiconductor switches 131 is provided under the dies 132 of the semiconductor switches 131 of the switch ICs 130. Therefore, even when the carbonized portion CN is formed in the insulating layers, no big problem occurs, although the wiring traces 162 are electrically connected together. Meanwhile, in the comparative example shown in FIG. 5(B), not only the wiring trace 162 on the high side of the semiconductor switches 131 but also the signal ground connection wiring trace 172 is provided under the die 132 of the semiconductor switch 131 on the right side. Accordingly, in the case where the carbonized portion CN is formed in the insulating layer, there arises a possibility that a short circuit is formed between the wiring traces 162 and 172, and an excessively large current flows therethrough.

Notably, in the comparative example shown in FIG. 5(B), when the switch IC 130 on the left side breaks and a carbonized portion CN is formed in the insulating layers under the broken switch IC 130, a short circuit may be formed between the wiring trace 162 on the high side of the semiconductor switches 131 and the wiring trace 163 on the low side thereof. In this case, there may arise a problem that, even when the semiconductor switches 131 (FIG. 2) are controlled and brought into the OFF state, the large current flowing through the resistive load 300 cannot be interrupted.

As described above, in the present embodiment, neither the signal ground connection wiring trace 172 nor the wiring trace 163 on the lower side of the semiconductor switches 131 is provided, and the wiring trace 162 on the high side of the semiconductor switches 131 is provided under the dies 132 of the semiconductor switches 131. Therefore, even in the case where the carbonized portion CN is formed in the insulating layers, the problem of a large leak current flowing between these wiring traces can be restrained.

Notably, as having been described with reference to FIGS. 3(A) through 3(D), from the viewpoint of preventing unnecessary current leak, it is most desired that, under the dies 132 of the semiconductor switches 131, only the wiring trace 162 on the high side of the semiconductor switches 131 be provided, and no other wiring traces be provided. However, in some cases, wiring traces other than the wiring trace 162 on the high side of the semiconductor switches 131 can be provided under the dies 132 of the semiconductor switches 131. For example, a wiring trace which has a small potential difference with respect to the wiring trace 162 on the high side of the semiconductor switches 131 can be provided under the dies 132 of the semiconductor switches 131, because no practical problem occurs even when a short circuit is formed between such a wiring trace and the wiring trace 162 on the high side of the semiconductor switches 131 due to formation of a carbonized portion CN. In view of this, it is preferred that, no other wiring traces which differ in potential from the wiring trace 162 on the high side of the semiconductor switches 131 be provided under the dies 132 of the semiconductor switches 131.

Also, of the plurality of wiring layers of the printed circuit board 150, several layers near the surface (hereinafter referred to as the "back surface") opposite the surface (hereinafter referred to as the "front surface") on which the switch ICs 130 are mounted are relatively small in the terms of the possibility that a carbonized portion CN is formed as a result of failure or breakage of the switch ICs 130. Accordingly, a plurality of layers located on the back surface side of the printed circuit board 150 may have a wiring trace other than the wiring trace 162 on the high side of the semiconductor switches 131. In other words, preferably, the multi-layer printed circuit board 150 is configured such that, of the N wiring layers of the printed circuit board 150 (N is an integer of 3 or greater), M wiring layers (M is an integer which is not less than 2 but not greater than N), the number of the M wiring layers being counted from the front surface on which the switch ICs 130 is mounted, have the wiring trace 162 on the high side of the semiconductor switches 131 without having the signal ground connection wiring trace 172 and the wiring trace 163 on the low side of the semiconductor switch ICs 130. In this case, it is preferred that M and N be equal to each other, although the integer M may be smaller than N.

It is preferred that the above-described various relations between the dies 132 and the wiring traces hold for all the switch ICs 130 mounted on the printed circuit board 150. Also, it is preferred that a region which includes a peripheral region extending over the entire perimeter of each die 132 and having a predetermined width satisfies the various relations with the above-mentioned wiring traces. This is because, even under the peripheral region of each die 132, a carbonized portion CN may be formed as a result of heat generation of the die 132. The "predetermined width" is preferably at least 0.5 mm, and more preferably set to 3 mm. When the width of the peripheral region of each die 132 where disposition of wiring traces is limited is set to such a value, it is possible to prevent occurrence of a failure as a result of formation of a carbonized portion CN while securing a sufficiently large spacing between components on the printed circuit board 150.

### D. Modifications

Notably, the present invention is not limited to the above-described example and embodiment, and may be implemented in various forms without departing from the scope of the invention.

### First modification:

In the above-described embodiment, the switch ICs are used to drive the resistive load on the high side. However, the switch ICs may be used to drive the resistive load on the low side.

### Second modification:

In the above-described embodiment, the thermal fuse 140 is used in the control apparatus 100. However, the thermal fuse 140 may be omitted.

### Third modification:

The control apparatus 100 of the above-described embodiment has a circuit configuration in which the battery 200 is connected to the current input terminals of the switch ICs 130, the current output terminals of the switch ICs 130 are connected to the input terminal of the resistive load 300, and the output terminal of the resistive load 300 is grounded. However, other various circuit configurations other than the above-mentioned circuit configuration can be employed.

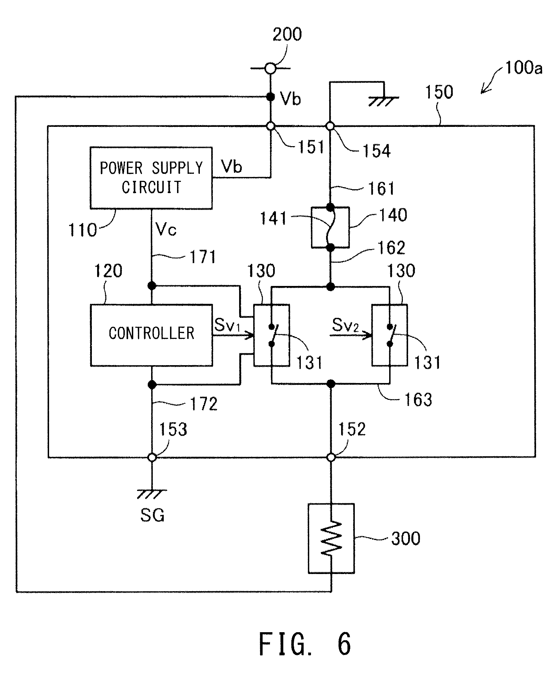

FIG. 6 is a block diagram showing an example of other circuit configurations of the control apparatus. In this control apparatus 100a, the battery 200 is connected to the input terminal of the resistive load 300, the output terminal of the resistive load 300 is connected to the current input terminals of the switch ICs 130, and the current output terminals of the switch ICs 130 are grounded through a ground terminal 154. In the case of such a control apparatus 100a, it is preferred that the wiring traces of the printed circuit board 150 be formed such that only the current path trace on the low side of the semiconductor switches 131 is present within a region which overlaps with the dies 132 of the semiconductor switches 131 of the switch ICs 130.

### [Description of Reference Numerals]

- 100:: control apparatus
- 102:: power supply input terminal
- 110:: power supply circuit
- 120:: controller IC
- 130:: switch IC
- 131:: semiconductor switch
- 132:: die (semiconductor chip)
- 140:: thermal fuse
- 141:: passive element
- 142:: lead wire
- 150:: printed circuit board
- 151:: power supply input terminal
- 152:: load connection terminal
- 153:: signal ground terminal
- 154:: ground terminal
- 161, 162, 163:: wiring trace
- 171:: wiring trace
- 172:: signal ground connection wiring trace
- 200:: battery
- 300:: resistive load

## Claims

1. A control apparatus (100) in which a switch IC (130) is disposed on a multi-layer printed circuit board (150) having N (N is an integer equal to or greater than 3) wiring layers (L1 - L4), the switch IC (130) being an IC package including a semiconductor switch (131) for driving a resistive load (300), the control apparatus being **characterized in that**
when M (M is an integer which is not less than 2 but not greater than N) wiring layers (L1 - L4) of the N wiring layers (L1 - L4) of the printed circuit board (150), the number of the M wiring layers being counted from a surface on which the switch IC (130) is mounted, and the switch IC (130) are projected in a thickness direction of the printed circuit board (150), in a region which overlaps with a die (132) of the semiconductor switch (131),
(i) a current path trace (162) on a high voltage side of the semiconductor switch (131) is present; and
(ii) a signal ground connection wiring trace (172) and a current path trace (163) on a low voltage side of the semiconductor switch (131) are not present.

2. A control apparatus according to claim 1, wherein, when the M wiring layers (L1 - L4) of the printed circuit board (150) and the switch IC (130) are projected in the thickness direction of the printed circuit board (150), other wiring traces which differ in potential from the current path trace (162) on the high voltage side of the semiconductor switch (131) are not present in the region which overlaps with the die (132) of the semiconductor switch (131).

3. A control apparatus according to claim 2, wherein, when the M wiring layers (L1 - L4) of the printed circuit board (150) and the switch IC (130) are projected in the thickness direction of the printed circuit board (150), wiring traces other than the current path trace (162) on the high voltage side of the semiconductor switch (131) are not present in the region which overlaps with the die (132) of the semiconductor switch (131).

4. A control apparatus according to any one of claims 1 to 3, wherein the integer M is equal to the integer N.

## Patentansprüche

1. Steuerungsvorrichtung (100), bei der ein Schalt-IC (130) auf einer mehrschichtigen Leiterplatte (150) angeordnet ist, die N (N ist eine ganze Zahl, die 3 oder mehr beträgt) Verdrahtungsschichten (L1-L4) hat, wobei der Schalt-IC (130) ein IC-Gehäuse ist, das einen Halbleiter-Schalter (131) zum Ansteuern einer ohmschen Last (300) enthält, und die Steuerungsvorrichtung **dadurch gekennzeichnet ist, dass**
wenn M (M ist eine ganze Zahl, die nicht kleiner ist als 2, jedoch nicht größer als N) Verdrahtungsschichten (L1-L4) der N Verdrahtungsschichten (L1-L4) der Leiterplatte (150), wobei die Anzahl der M Verdrahtungsschichten von einer Fläche aus gezählt wird, auf der der Schalt-IC (130) montiert ist, und der Schalt-IC (130) in einer Dickenrichtung der Leiterplatte (150) projiziert werden, in einem Bereich, der sich mit einem Chip (132) des Halbleiter-Schalters (131) überlappt,
a) eine Stromweg-Bahn (162) an einer Hochspannungsseite des HalbleiterSchalters (131) vorhanden ist; und
b) eine Signal-Erdverbindungs-Leiterbahn (172) und eine Stromweg-Bahn (163) an einer Niederspannungsseite des Halbleiter-Schalters (131) nicht vorhanden sind.

2. Steuerungsvorrichtung nach Anspruch 1, wobei, wenn die M Verdrahtungsschichten (L1-L4) der Leiterplatte (150) und der Schalt-IC (130) in der Dickenrichtung der Leiterplatte (150) projiziert werden, keine anderen Verdrahtungsschichten, deren Potential sich von dem der Stromweg-Bahn (162) an der Hochspannungsseite des Halbleiter-Schalters (131) unterscheidet, in dem Bereich vorhanden sind, der sich mit dem Chip (132) des Halbleiter-Schalters (131) überlappt.

3. Steuerungsvorrichtung nach Anspruch 2, wobei, wenn die M Verdrahtungsschichten (L1-L4) der Leiterplatte (150) und der Schalt-IC (130) in der Dickenrichtung der Leiterplatte (150) projiziert werden, keine anderen Leiterbahnen außer der Stromweg-Bahn (162) an der Hochspannungsseite des Halbleiter-Schalters (131) in dem Bereich vorhanden sind, der sich mit dem Chip (132) des Halbleiter-Schalters (131) überlappt.

4. Steuerungsvorrichtung nach einem der Ansprüche 1 bis 3, wobei die ganze Zahl M der ganzen Zahl N gleich ist.

## Revendications

1. Appareil de commande (100) dans lequel un circuit intégré de commutation (130) est disposé sur une carte à circuit imprimé (150) multicouche comportant N (N étant un nombre entier supérieur ou égal à 3) couches de câblage (L1 à L4), le circuit intégré de commutation (130) étant un boîtier de circuit intégré incluant un interrupteur à semi-conducteur (131) destiné à attaquer une charge résistive (300), l'appareil de commande étant **caractérisé en ce que** :
lorsque M (M étant un nombre entier qui n'est pas inférieur à 2 mais pas supérieur à N) couches de câblage (L1 à L4) parmi les N couches de câblage (L1 à L4) de la carte à circuit imprimé (150), le nombre de M couches de câblage étant compté depuis une surface sur laquelle est monté le circuit intégré de commutation (130), et le circuit intégré de commutation (130) sont projetés dans la direction de l'épaisseur de la carte à circuit imprimé (150), dans une zone qui chevauche une puce (132) de l'interrupteur à semi-conducteur (131), alors :
(i) une piste de courant (162) sur le côté haute tension de l'interrupteur à semi-conducteur (131) est présente, et
(ii) la piste de connexion du signal de masse (172) et une piste de courant (163) du côté basse tension de l'interrupteur à semi-conducteur (131) ne sont pas présentes.

2. Appareil de commande selon la revendication 1, dans lequel, lorsque les M couches de câblage (L1 à L4) de la carte à circuit imprimé (150) et le circuit intégré de commutation (130) sont projetés dans la direction de l'épaisseur de la carte à circuit imprimé (150), d'autres pistes de câblage qui sont à un potentiel différent de la piste de courant (162) du côté haute tension de l'interrupteur à semi-conducteur (131) ne sont pas présentes dans la zone qui chevauche la puce (132) de l'interrupteur à semi-conducteur (131).

3. Appareil de commande selon la revendication 2, dans lequel, lorsque les M couches de câblage (L1 à L4) de la carte à circuit imprimé (150) et le circuit intégré de commutation (130) sont projetés dans la direction de l'épaisseur de la carte à circuit imprimé (150), des pistes de câblage différentes de la piste de courant (162) du côté haute tension de l'interrupteur à semi-conducteur (131) ne sont pas présentes dans la zone qui chevauche la puce (132) de l'interrupteur à semi-conducteur (131).

4. Appareil de commande selon l'une quelconque des revendications 1 à 3, dans lequel le nombre entier M est égal au nombre entier N.
